Europäisches Patentamt

European Patent Office

Office européen des brevets

(11) Publication number: **0 266 315**
**A1**

# EUROPEAN PATENT APPLICATION

(21) Application number: 87830333.8

(22) Date of filing: 22.09.87

(51) Int. Cl.4: **C 23 C 14/54**
**C 23 C 14/24**

(30) Priority: 24.09.86 IT 948286

(43) Date of publication of application:
**04.05.88 Bulletin 88/18**

(84) Designated Contracting States: **DE FR GB NL**

(71) Applicant: **Officine Galileo S.p.A.**
**via A.Einstein, 35**
**I-50013 Campi Bisenzio Firenze (IT)**

(72) Inventor: **Carletti, Alessandro**
**Via Leopoldo Pellas No. 36**
**I-50141 Firenze (IT)**

(74) Representative: **Mannucci, Gianfranco, Dott.-Ing.**
**Ufficio Tecnico Ing. A. Mannucci Via della Scala 4**
**I-50123 Firenze (IT)**

(54) **Method and equipment for the control and the regulation of the evaporation of a metal such as aluminum or other, in plants for metalization under vacuum.**

(57) The aluminum wire (A) advances towards a heated body (1) whose surface is incandescent for the evaporation, with feeding means of the wire at a velocity that can be set; a signal is drawn, which depends on the timing related to the formation of the drops of melted metal, and the temperature of the surface is controlled depending on said timing.

Fig.1

## Description

"METHOD AND EQUIPMENT FOR THE CONTROL AND THE REGULATION OF THE EVAPORATION OF A METAL SUCH AS ALUMINUM OR OTHER, IN PLANTS FOR METALIZATION UNDER VACUUM"

This invention relates to the control and regulation of the evaporation of a metal, such as aluminum or other, from the evaporating sources that are used in the metalization plants for the metalization of substrata such as plastic films, paper or other. These plants, in particular when the continuous metalization of continuous layers such as films or paper is carried out, must be regulated as far as the transit velocity of the material to be metalized is concerned, as far as the feeding of the wire of metal to be melted and evaporated is concerned, and as far as the temperature of the incandescent surface that must evaporate the metallic wire is concerned, that melts near this surface, usually in forming drops.

The invention relates to the control of the thermal sources, that generally are heated by Joule effect, which are of use for the evaporation of aluminum or other metallic material that is of use for the metalization.

The control according to the invention is actuated by exploiting the characteristics of the phenomenon of the melting of the metal wire that has to be vaporized and is addressed on the incandescent surface that forms the source of heat for the generation of the vapors of aluminum or other metal. The control and the consequent regulation are carried out in such a way that the timing of the drops of melted metal, which fall on the incandescent surface of the source, is optimized.

Therefore it is a first object of the invention to provide a method of control and regulation of the evaporation phenomenon of a metal - such as aluminum -in the evaporators for under vacuum metalization plants including a heated body with an incandescent surface for the evaporation of a metallic wire, and means for feeding of the wire itself towards said surface with a velocity that can be set,the wire melting near the surface and forming drops of liquid metal, which fall on the surface and evaporates. According to the invention a signal depending on the timing of formation of the drops of melted metal is drawn and the temperature of the surface is set depending on said timing.

The signal is processed depending on the duration of said signal as well as on the timing.

The signal can be an electric signal depending on the intermittent metallic contact that takes place between the heated surface and the fed wire.

A second object of the invention is to provide an equipment to actuate the above method, in a metalization plant that includes a body heated by incandescent surface for the evaporation of the melted metal falling thereon, and means for feeding of the wire of metal to be evaporated. According to the invention, means are provided for drawing a signal depending on the timing of formation of the drops melted metal to be evaporated, means for processing said signal depending on the frequency thereof, means for controlling the temperature of said body depending on said elaborated signal.

The equipment can include also means for processing the signal depending on the duration thereof.

Moreover means for varying the velocity of feeding and means for varying the elaboration of the signal depending on said velocity of feeding can be provided.

The invention is described below and it is illustrated by the accompanying drawing, that shows a pratical non restricting exemplification of the invention itself. In the drawing:

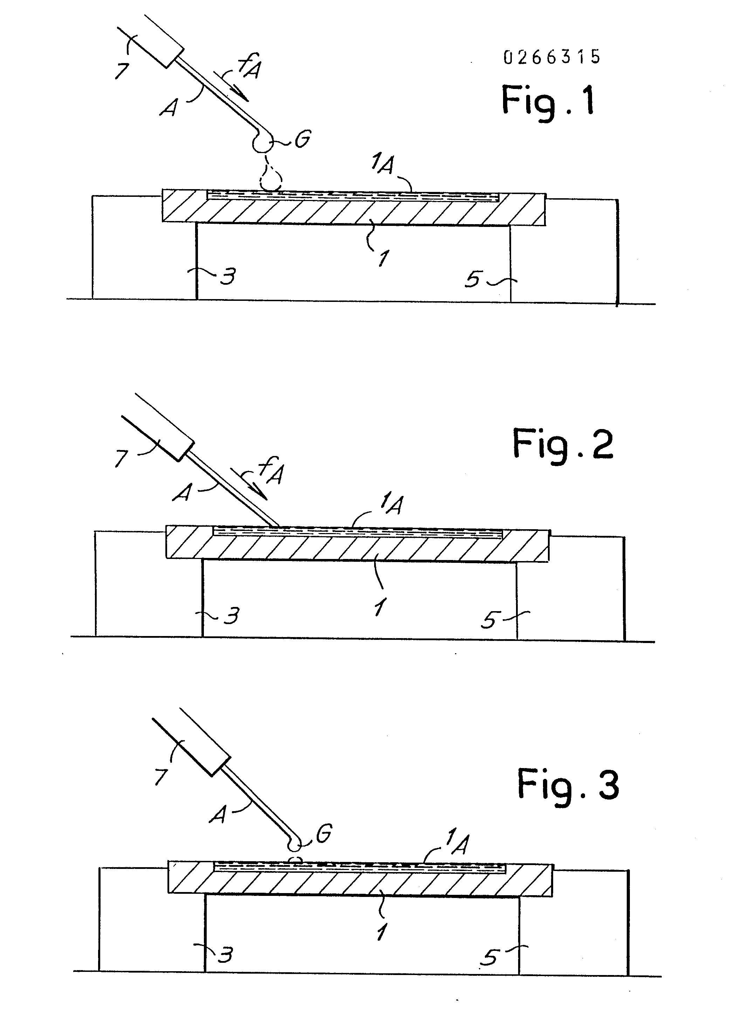

Figs.1, 2 and 3 show three possible conditions of the phenomenon of the melting.

As it can be seen on the drawing, an incandescent surface 1A is formed by a body 1 that is heated generally by Joule effect, by contact with two blocks 3 and 5, between which a potential difference is established to obtain the heating, this potential difference being for example 10 Volt as an order of magnitude and the temperature of the surface 1A being about 1400-1500°C in case of metalization using aluminum. The aluminum is fed under the form of a wire A suitably guided by a means 7 and made advancing according to the arrow fA towards the surface 1A; the wire is fed at a constant velocity that can be set, while also the temperature of the surface 1A can be set according to the criteria of the invention.

Before evaporating aluminum melts by the effect of the radiant heat coming from the surface 1A and forms drops that fall on the surface and evaporate from said surface.

The invention permits a regulation by exploiting the parameter that is constituted by the falling timing of the drops of aluminum which form on the wire and deposit themselves on the surface 1A. It has been found that if the temperature is too high the frequence of the contact signals between aluminum and the body 1, due to the metallic contact established by the drop that is formed, is reduced in respect to the optimum, and the drop that is formed shows a greater size and consequently the resulting evaporation is discontinuous, with inconveniences on the regularity of the metalization of the material passing at constant velocity. On the contrary, when the temperature of the surface 1A tends to decrease, the frequency increases until a disappearance of the drops and a continuous contact with the evaporating surface takes place. The optimum frequency is to be stabilized by setting. The optimum is achieved as shown in Fig.3 with a preset temperature of the surface 1A and with the formation of relatively small drops G, whose formation is characterized by an optimum frequency that can be easily found, thus obtaining a substantially constant amount of evaporation.

The conditions of Fig.1 take place with high temperature, which causes a melting by way of remote radiation, big sparse drops falling from the wire. The conditions of Fig.2 take place with a relatively low temperature: the wire A touches continuously the evaporating source 1, 1A and melts on this surface. With the optimum temperature values, the conditions of Fig.3 take place, with frequent and small drops which establish frequent contacts.

Through the control of the contact frequency and thus the control of the drop formation and through the duration of the signals, it is possible on one hand to control the optimum conditions and the uniformity of evaporation, and on the other hand it is also possible to obtain a variation of the amount of evaporated metal by processing the average continuous value with an integration, to reach the desired formation of a more or less thick layer of metalization on the product in transit. The capacity shall be imposed by a variation of the advancement velocity of the metal and by an optimization of the evaporation temperature obtained by the above described method; the capacity can be imposed by evaluations arising from surveys on the piece or on the material being subjected to the metalization treatment.

The parameters affecting the phenomenon are summarized in the above explanation, but obviously they are various and complemental each other; after all, the survey of the phenomenon through the frequency and the duration of the signals as above indicated is enough to assure control and regulations, to obtain the stated and desired results, in the metalization of the materials and objects being treated.

It must be understood that the drawing shows an exemplification, which is shown only as a practical demonstration of the invention, being the invention able to vary in the forms and the arrangements, without any way going out from the scope of the principles informing the invention itself.

## Claims

1. A method for the control and the regulation of the evaporation phenomenon of a metal - such as aluminum - in the evaporators for under vacuum metalization plants including a heated body by an incandescent surface for the evaporation of a metal wire, and means for the feeding of the wire, towards said surface, with a velocity that can be set, which wire melts near the surface and forms drops of liquid metal which fall on the surface and evaporate, characterized in that a signal depending on the timing of formation of the drops of melted metal is drawn, and the temperatures of the surface is controlled depending on said timing.

2. A method according to claim 1, characterized in that the signal, is processed depending on the duration of said signal as well as on the timing.

3. A method according to claim 2, characterized in that the signal is an electric signal depending on the intermittent metallic contact that takes place between the heated surface and the fed wire.

4. An equipment for the control and the regulation of the evaporation phenomenon of a metal - such as aluminum - in a metalization plant, which includes a heated body with incandescent surface for the evaporation of the melted metal falling thereon, and means for the feeding of the metal wire to be evaporated, characterized in that it includes means for drawing a signal depending on the timing of formation of the drops of melted metal to be evaporated, means for processing said signal depending on the frequency thereof, means for controlling the temperature of said body depending on said elaborated signal.

5. Equipment according to claim 5, characterized in that it includes also means for processing the signal depending on its duration.

6. Equipment according to claim 6, characterized in that it also includes means suitable for varying the feeding velocity of the wire and means suitable for varying the processing of the signal depending on said feeding velocity.

0266315

Fig.1

Fig.2

Fig.3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 055 344 (ROCKWELL INTERNATIONAL CORP.) --- | | C 23 C 14/54 |
| A | US-A-2 899 528 (W. REICHELT) --- | | C 23 C 14/24 |
| A | DE-B-1 079 919 (W.C. HERAEUS) --- | | |
| A | US-A-2 665 229 (F.W. SCHULER) --- | | |
| A | US-A-3 506 803 (T.G. HART) --- | | |
| A | IBM TECHNICAL DISCLOSURE BULLETIN, vol. 14, no. 10, March 1972, page 3131, New York, US; M.S. EFFRON: "Homogeneous film evaporation of differing vapor pressure materials" --- | | |
| A | GB-A-1 203 069 (VEB HOCHVAKUUM DRESDEN) --- | | |
| A | POLYTECHNISCH TIJDSCHRIFT/WERKTUIGBOUW, vol. 38, no. 2, Februry 1983, pages 51-55, The Hague, NL, W.G. ESSERS et al.: "Het penetratiemechanisme bij MIG-lassen" ----- | | TECHNICAL FIELDS SEARCHED (Int. Cl.4) C 23 C B 23 K |

The present search report has been drawn up for all claims

| Place of search | Date of completion of the search | Examiner |
|---|---|---|
| THE HAGUE | 28-01-1988 | ELSEN D.B.A. |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P0401)